# EUROPÄISCHE PATENTSCHRIFT

(11) **EP 1 176 744 B1**
(45) Veröffentlichungstag und Bekanntmachung des Hinweises auf die Patenterteilung: **06.06.2007**
(21) Anmeldenummer: 01440198.8
(22) Anmeldetag: 02.07.2001
(51) Int. Cl.: H04J 3/06

(54) **Taktversorgungseinheit**
Clock supply device
Dispositif d'alimentation d'horloge

(30) Priorität: 28.07.2000 DE 10036827
(43) Veröffentlichungstag der Anmeldung: 30.01.2002
(73) Patentinhaber: Alcatel Lucent, 75008 Paris (FR)
(72) Erfinder: Höfs, Henning, 30855 Langenhagen (DE); Puschmann, Norbert, 30826 Garbsen (DE)
(74) Vertreter: Menzietti, Domenico

(56) Entgegenhaltungen:
- EP-A- 0 652 642
- US-A- 5 748 569
- PATENT ABSTRACTS OF JAPAN Bd. 1999, Nr. 10, 31. August 1999 (1999-08-31) & JP 11 136633 A (VICTOR CO OF JAPAN LTD), 21. Mai 1999 (1999-05-21)

## Beschreibung

Die Erfindung bezieht sich auf eine Taktversorgungseinheit.

Aus US 5,748,569 ist eine Vorrichtung und ein Verfahren zum Abgleichen eines Takts und zum Umschalten bekannt. Diese Schrift zeigt Möglichkeiten auf zum Synchronisieren eines Taktes auf einen anderen nach Frequenz und Phase und zur Auswahl eines der beiden Takte. Diese Schrift zeigt eine Reihe von Merkmalen auf, die, wenn auch teilweise mit anderer Funktion, mit Merkmalen der vorliegenden Erfindung übereinstimmen. Hiervon geht die Erfindung aus.

In digitalen Übertragungssystemen wird für die Taktversorgung in einer Zentrale ein Mastertakt generiert, der über das digitale Übertragungssystem zu lokalen digitalen Übertragungseinrichtungen übertragen wird. In den digitalen Übertragungseinrichtungen wird jeweils ein lokaler Slavetakt generiert, der auf den empfangenen Mastertakt synchronisiert wird. Die digitalen Übertragungseinrichtungen, z.B. Datenübertragungseinrichtungen, werden überwiegend in Subracks untergebracht, die über eine zentrale Taktversorgungseinheit verfügen. Die Taktversorgungseinheit generiert den Slavetakt, der als zentraler Systemtakt verwendet wird und in einem synchronen System über das Backpanel, das einen Bus zur Systemtaktverteilung enthält, auf sämtliche Funktionseinheiten verteilt, die in den Subracks untergebracht sind.

Wird die Funktion der zentralen Taktversorgung beeinträchtigt oder fällt sie aus, so kann sich dies auf die gesamte Datenübertragungseinrichtung auswirken. Aus diesem Grund wird dazu übergegangen, die Taktversorgungseinheit der Subracks redundant aufzubauen. Dies bedeutet, dass über eine zweite Taktversorgungseinheit ein vom Slavetakt unabhängiger redundanter Takt lokal generiert wird. Ist der Slavetakt gestört, kann auf den redundanten Takt umgeschaltet werden. Der redundante Takt ist dann der neue Slavetakt, der die Taktversorgung der Subracks übernimmt. Die Umschaltung auf den redundanten Takt kann von den Taktversorgungseinheiten autark durchgeführt werden oder in einem administrativen Fall von der Zentrale aus.

Bei der Umschaltung kommt es zu einer Unterbrechung einer in diesem Augenblick bestehenden Verbindung, z.B. einer Telefonverbindung, die den Verlust von Daten bedeuten kann. Es ist eine Neusynchronisation des redundanten Taktes auf den Mastertakt durchzuführen. Dies erfordert Zeit. Die unterbrochene Verbindung muss neu aufgebaut werden.

Es ist Aufgabe der Erfindung, eine Taktversorgungseinheit zu schaffen, bei der bei der Umschaltung vom Slavetakt auf den redundanten Takt möglichst keine Beeinträchtigung des Übertragungssystems erfolgt.

Diese Aufgabe wird gelöst durch eine Taktversorgungseinheit gemäß Patentanspruch 1.

Es wird eine erste Empfangseinheit verwendet, um den zentralen Systemtakt vom Backpanel abzugreifen. In der ersten Empfangseinheit tritt eine Zeitverzögerung auf. Um diese Zeitverzögerung zu kompensieren, wird eine zweite Empfangseinheit verwendet, die identisch zur ersten Empfangseinheit aufgebaut ist und die gleiche Zeitverzögerung wie die erste Empfangseinheit aufweist. Der redundante Takt wird der zweiten Empfangseinheit zugeführt und erfährt dadurch die gleiche Zeitverzögerung wie der zentrale Systemtakt in der ersten Empfangseinheit. In einem Phasendetektor können nun zentraler Systemtakt und redundanter Takt exakt miteinander verglichen werden. Der redundante Takt wird nun auf den zentralen Takt synchronisiert. Erst nach erfolgreicher Synchronisation erfolgt die Umschaltung vom Slavetakt auf den redundanten Takt. Dies bedeutet, dass für den Fall, dass der Slavetakt gestört ist, der redundante Takt vor der Umschaltung auf den gestörten Takt synchronisiert wird und erst nach erfolgter Synchronisation umgeschaltet wird. Dies hat den Vorteil, dass im Umschaltzeitpunkt kein Phasensprung auftritt. Eine bestehende Verbindung wird nicht unterbrochen. Nach der Umschaltung wird der redundante Takt auf den Mastertakt synchronisiert und die Störung auf diese Weise behoben.

Der redundante Takt wird somit vor der Umschaltung auf den Slavetakt synchronisiert. Im Umschaltzeitpunkt haben redundanter Takt und Slovetakt die gleiche Frequenz und die gleiche Phase.

Vorteilhafte Ausgestaltungen der Erfindung sind den abhängigen Ansprüchen sowie der nachfolgenden Beschreibung zu entnehmen.

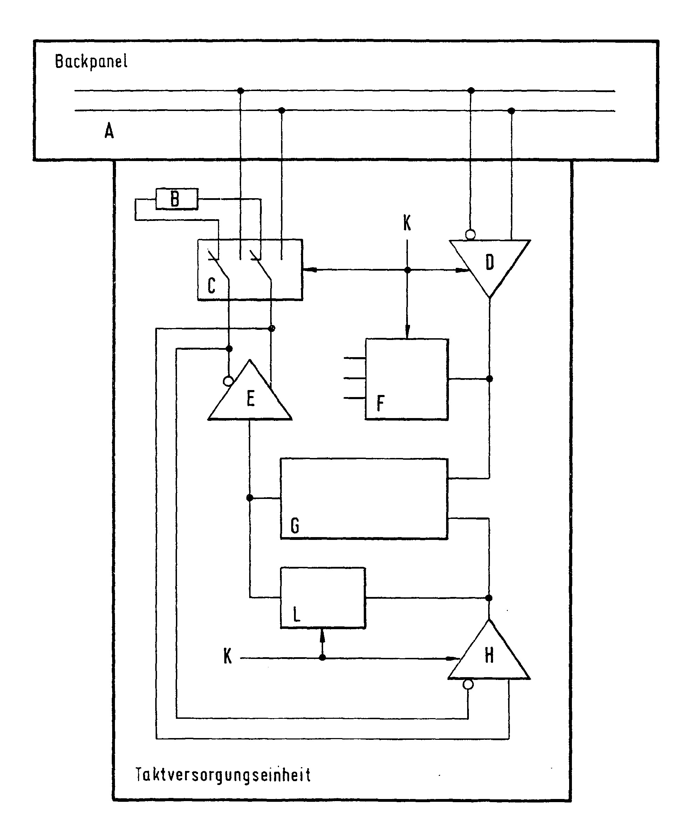

Ein Ausführungsbeispiel der Erfindung wird im folgenden unter Zuhilfenahme einer Figur erläutert. Die Figur zeigt ein Blockschaltbild einer Taktversorgungseinheit für einen redundanten Takt und ein Backpanel. Die Taktversorgungseinheit für den Slavetakt kann identisch zur Taktversorgungseinheit für den redundanten Takt aufgebaut sein und ist ebenso wie die Subracks einer digitalen Übertragungseinrichtung, z.B. eines Cross Connects, aus Gründen der Übersichtlichkeit nicht dargestellt.

Die Taktversorgungseinrichtung beinhaltet eine erste Empfangseinheit D. Die Empfangseinheit D dient dazu, den von der Taktversorgungseinheit für den Slavetakt zur Verfügung gestellten zentralen Systemtakt vom Backpanel, das einen Bus zur Systemtaktverteilung beinhaltet, abzugreifen. Die Empfangseinheit D hat einen Steuereingang, über den sie aktiv und passiv geschaltet werden kann. Für den Fall, dass die digitale Übertragungseinrichtung mit dem Slavetakt arbeitet ist die Empfangseinheit D passiv geschaltet. Für den Fall, dass eine Umschaltung vom Slavetakt auf den redundanten Takt erfolgen soll, z.B. auf Grund einer Störung des Slavetaktes, wird die Empfangseinheit D aktiv geschaltet. Die Empfangseinheit D empfängt dann den zentralen Systemtakt und leitet diesen zu einem Phasenregelkreis G, einer sog. PLL weiter. Der Phasenregelkreis G beinhaltet einen Phasendetektor und einen spannungsgesteuerten Oszillator. Der Oszillator generiert den redundanten Takt und wird über den Phasendetektor geregelt. Der Phasendetektor hat zwei Eingänge und einen Ausgang. An den einen Eingang wird der zentrale Systemtakt angelegt. Der Ausgang liefert eine Ausgangspannung, die als Regelspannung für den Oszillator dient. Zwischen Phasendetektor und Oszillator sind optional weitere Bauelemente geschaltet, wie z.B. ein Schleifenfilter. Der Ausgang des Oszillators ist über eine Rückkoppelschleife mit dem zweiten Eingang des Phasendetektors verbunden. Auf diese Art und Weise wird die Phase des redundanten Taktes mit der Phase des zentralen System taktes verglichen. In der Rückkoppelschleife befindet sich eine Rückkoppelschleife aus einer Sendeeinheit E und einer zweiten Empfangseinheit H. Am Ausgang der Sendeeinheit E wird ein derart aufbereiteter redundanter Takt zur Verfügung gestellt, der direkt als zentraler Systemtakt auf den Bus zur Systemtaktverteilung gegeben werden kann. Dieser aufbereitete redundante Takt wird der Empfangseinheit H zugeführt, in der er die gleiche Zeitverzögerung erfährt, wie der abgegriffene zentrale Systemtakt in der Empfangseinheit D. Die Empfangseinheiten D und H sind identisch aufgebaut und dienen der Umsetzung der speziellen Systemtakteigenschaften in Oszillatortakteigenschaften. Sie beinhalten z.B. Wandler und Pegelumsetzer. Beide Empfangseinheiten D und H werden in geringen Abstand zueinander angeordnet und befinden sich in einem Gehäuse. Dadurch wird erreicht, dass sich Temperaturschwankungen, die die Funktionalität beeinflussen können, sich gleichermaßen auf beide Empfangseinheiten auswirken und sich gegebenenfalls negative Auswirkungen somit beim Vergleich im Phasendetektor gegeneinander aufheben. Auf diese Art und Weise liegen am Phasendetektor zwei Takte an, die die gleiche Phasenverzögerung erfahren haben und somit ohne Phasensprung aufeinander synchronisiert werden können. Der redundante Takt wird damit auf den Slavetakt synchronisiert. Nach erfolgter Synchronisation erfolgt die Umschaltung von Slavetakt auf redundanten Takt. Im Umschaltzeitpunkt haben redundanter Takt und Slavetakt die gleiche Frequenz und die gleiche Phase. Es tritt kein Phasensprung auf. Die Umschaltung kann on-line durchgeführt werden, d.h. ohne Beeinträchtigung einer bestehenden Verbindung.

Die Taktversorgungseinheit beinhaltet ferner einen Umschalter C und eine Leitungsnachbildung B. Umschalter C hat einen Eingang und zwei Ausgänge. Der Eingang ist mit dem Ausgang der Sendeinheit E verbunden. Der eine Ausgang des Umschalters C ist mit der Leitungsnachbildung B verbunden, der andere mit dem Bus zur Systemtaktverteilung. Umschalter C hat einen Steuereingang über den der Eingang des Umschalters C wahlweise mit dem einen oder dem anderen Ausgang des Umschalters C verbunden werden kann. Vor der Umschaltung vom Slavetakt auf den redundanten Takt ist der Eingang mit der Leitungsnachbildung B verbunden. Die Leitungsnachbildung B ist beispielsweise aus passiven Bauelementen aufgebaut und dient der Simulation einer realen Leitung eines Busses zur Systemtaktverteilung mit den gleichen elektrischen Parametern. Die Leitungsnachbildung B ist im einfachsten Fall z.B. ein 100 Ohm Widerstand oder ein RLC-Glied. Wenn nun der redundante Takt über die Sendeinheit E mit der Leitungsnachbildung B verbunden ist können auf diese Weise die realen Verhältnisse inklusive Last simuliert werden. Der Phasenvergleich im Phasendetektor kann somit unter annähernd realen Betriebsbedingungen durchgeführt werden. Nach erfolgreicher Synchronisation erfolgt die Umschaltung auf den redundanten Takt durch Einspeisen des redundanten Taktes in den Bus zur Systemtaktverteilung A des Backpanels über Umschalter C. Im Umschaltzeitpunkt erfolgt keinerlei Beeinträchtigung, da der redundante Takt durch Phasenvergleich und Regelung sowie Bussimulation auf eine nahtlose Übergabe vorbereitet ist.

Die Taktversorgungseinheit beinhaltet des weiteren einen Teiler L. Teiler L ist als Frequenzteiler ausgeführt. Beispielsweise wird vom Oszillator ein redundanter Takt mit einer Frequenz von 8 MHz erzeugt. Im Teiler, der z.B. auch als Zähler ausgeführt sein kann, wird z. B. mit einem Faktor 4 der redundante Takt in einen Takt mit 4 MHz umgesetzt. Dieser 4 MHz Takt wird dann nach der Umschaltung dem Phasendetektor zugeführt anstelle des Ausgangssignals der Empfangseinheit H. Ebenso ist ein Referenztakt-Umschalter F vorgesehen zur Auswahl mindestens eines Referenztaktes. Nach der Umschaltung wird anstelle des Ausgangssignals der Empfangseinheit D ein Referenztakt über den Referenztaktumschalter F dem Phasendetektor zugeführt. Der Referenztakt ist beispielsweise der Mastertakt. Die Umschaltung von Slavetakt auf redundanten Takt wird so vollzogen, dass die Taktflanken zeitlich deckungsgleich sind. Die Regelzeit der Taktversorgungseinheit soll dabei schneller sein als die Regelzeit des Slavetaktes, damit ein Nachziehen der Taktversorgungseinheit gewährleistet ist. Wird der Umschaltvorgang eingeleitet, so wird zunächst der redundante Takt zusätzlich zum Slavetakt in den Bus zur Systemtaktverteilung eingespeist. Erst anschließend wird der Slavetakt vom Bus entfernt. Ein schnelles Nachziehen des Phasenregelkreises G wird dadurch erreicht, dass über den Referenztakt-Umschalter F ein Referenztakt mit einer gegenüber dem Systemtakt niedrigeren Frequenz dem Phasendetektor zugeführt wird. Der Referenztakt ist z.B. der Mastertakt. Am Referenztakt-Umschalter F liegen Referenztakte an, die aus externen Schnittstellensignalen zurückgewonnen wurden. Dies sind z.B. T3an (zentrale Netztaktversorgung im Bereich einer Vermittlungsstelle), Takt einer SDH-Schnittstelle (STM1, STM4) und/oder der Takt einer 2 Mbit/s G.703-Schnittstelle (V5.X einer digitalen Vermittlungsstelle). Da ein Referenztakt gegebenenfalls auch ausfallen kann, liegen am Referenztakt-Umschalter F mehrere Referenztakte zur Auswahl an.

Taktversorgungseinheit für redundanten Takt und Slavetakt sind im Idealfall identisch aufgebaut. Für den Fall einer Störung des Slavetaktes wird nach einer Aufsynchronisation auf den redundanten Takt umgeschaltet. Nach dem Beheben kann wieder auf den Slavetakt zurückgeschaltet werden. Es ist beispielsweise eine gemeinsame Steuerung vorgesehen, beinhaltend z.B. einen Prozessor, der die Ansteuerung der Einheiten in den Taktversorgungseinheiten für den Slavetakt und den redundanten Takt übernimmt und die Umschaltung durchführt. Der Prozessor ist entsprechend programmiert. Die Steuerung erfolgt wie folgt: Im Falle eines ungestörten Slavetaktes wird der Slavetakt auf den Mastertakt synchronisiert und nach einer Umsetzung als Systemtakt auf den Bus zur Systemtaktverteilung gegeben. Referenzsignale von diversen Schnittstellenkarten können zur Feinjustage des Slavetaktes herangezogen werden. Im Falle eines gestörten Slavetaktes wird der redundante Takt auf den Systemtakt synchronisiert und anschließend auf den Bus zur Systemtaktverteilung gegeben. Anschließend wird der Slavetakt vom Bus zur Systemtaktverteilung entfernt und der redundante Takt auf den Mastertakt synchronisiert. Ist der Slavetakt wieder ungestört wird dieser zunächst auf den Systemtakt synchronisiert und anschließend zusätzlich zum redundanten Takt auf den Bus zur Systemtaktverteilung gegeben. Anschließend wird der redundante Takt vom Bus entfernt und der Slavetakt auf den Mastertakt synchronisiert. Eine Umschaltung von Slavetakt auf redundanten Takt oder umgekehrt kann auch von der Zentrale zu jedem beliebigen Zeitpunkt erfolgen.

## Patentansprüche

1. Taktversorgungseinheit
a: zur Umschaltung von einem gestörten Slavetakt
b: - auf einen redundanten Takt, beinhaltend
c: einen Phasendetektor (G) zum Vergleich der Phase eines ersten Taktes mit der Phase eines zweiten Taktes,
d: eine erste Empfangeinheit (D)
e: - zum Abgreifen eines in einen Systemtakt-Bus eingespeisten Systemtaktes, der dem umzuschaltenden, gestörten Slavetakt entspricht,
f: - und zum Weiterleiten des Systemtaktes zum Phasendetektor (G),
g: einen Oszillator
h: - zum Generieren des redundanten Taktes,
i: eine zweite Empfangseinheit (H), die die gleichen Parameter wie die erste Empfangseinheit (D) aufweist
j: - und zum Empfang des redundanten Taktes und zum Weiterleiten des redundanten Taktes
k: - zum Phasendetektor (G) dient,
l: eine Sendeeinheit (E),
m: - wobei die Sendeeinheit (E) derart zwischen den Oszillator und die zweite Empfangseinheit (H) geschaltet ist, dass der im Oszillator generierte redundante Takt über die Sendeeinheit (E) der zweiten Empfangseinheit (H) zugeführt wird,
n: einen Umschalter (C) mit einem Eingang und zwei Ausgängen, wobei der Eingang des Umschalters (C) mit dem Ausgang der Sendeeinheit (E) verbunden ist, der eine Ausgang des Umschalters (C) mit einer Leitungsnachbildung (B) verbunden ist, die geeignet ist, den Systemtakt-Bus zu simulieren, und der andere Ausgang mit dem Systemtakt-Bus verbunden ist,
o: einen als Frequenzteiler ausgeführten Teiler (L),
p: - der zwischen Oszillator und Phasendetektor (G) geschaltet ist, wobei der Teiler (L) und die zweite Empfangseinheit (H) jeweils einen Steuereingang zum Aktiv- und Passivschalten des Teilers (L) und der zweiten Empfangseinheit (H) aufweisen und
q: einen Referenztakt-Umschalter (F) dessen Ausgang mit dem Ausgang der ersten Empfangseinheit (D) verbunden ist und zur Bereitstellung mindestens eines Mastertaktes dient, wobei der Referenztakt-Umschalter (F) und die erste Empfangseinheit (D) jeweils einen Steuereingang zum Aktiv- und Passivschalten des Referenztakt-Umschalters (F) und der ersten Empfangseinheit (D) aufweisen,
r: wobei der Umschalter (C) geeignet ist, den von der Sendeeinheit (E) empfangenen Takt auf den Systemtakt-Bus oder die Leitungsnachbildung (B) zu schalten, und wobei der Referenztakt-Umschalter (F) geeignet ist, dem Phasendetektor (G) mindestens einen Referenztakt zuzuführen, dessen Frequenz niedriger als die Frequenz des Systemtaktes ist.

2. Taktversorgungseinheit noch Anspruch 1, **dadurch gekennzeichnet, dass** der Oszillator als spannungsgesteuerter Oszillator ausgebildet ist, dessen Steuerspannung abhängig ist vom Ausgangssignal der Phasendetektors (G).

3. Taktversorgungseinheit nach Anspruch 1, **dadurch gekennzeichnet, dass** die erste (D) und die zweite Empfangseinheit (H) die gleiche Zeitverzögerung aufweisen.

4. Taktversorgungseinrichtung zur Umschaltung von einem gestörten Slavetakt auf einen redundanten Takt beinhaltend zwei Toktversorgungseinheiten nach Anspruch 1 und eine gemeinsame Steuereinheit zur Ansteuerung der Umschalter (C) sowie zum Aktiv- und Passivschalten der Referenztakt-Umschalter (F), der Teiler (L) und der ersten und zweiten Empfangseinheiten (D, H) der Taktversorgungseinheiten.

5. Verfahren
s. zum Umschalten von einem gestörten Slavetakt
t. - auf einen redundanten Takt, mit folgenden Schritten:
u. Abgreifen eines in einen Systemtakt-Bus eingespeisten Systemtaktes, der dem umzuschaltenden, gestörten Slavetakt entspricht,
v. Generieren eines redundanten Taktes
w. - und Synchronisieren des redundanten Taktes auf den Systemtakt,
x. Einspeisen des synchronisierten, redundanten Taktes in den Systemtakt-Bus,
y. Unterbinden des weiteren Einspeisens des gestörten Slavetaktes in den Systemtakt-Bus, und
z. Synchronisieren des redundanten Taktes auf einen empfangenen Mastertakt, der eine gegenüber dem Systemtakt niedrigere Frequenz aufweist

## Claims

1. Clock supply unit
a: for changing over from a disturbed slave clock
b: - to a redundant clock, containing
c: a phase detector (G) to compare the phase of a first clock with the phase of a second clock,
d: a first reception unit (D)
e: - to tap a system clock, which is fed into a system clock bus, and which corresponds to the disturbed slave clock to be changed over,
f: - and to pass on the system clock to the phase detector (G),
g: an oscillator
h: - to generate the redundant clock,
i: a second reception unit (H), which has the same parameters as the first reception unit (D)
j: - and is used to receive the redundant clock and to pass on the redundant clock
k: - to the phase detector (G),
l: a transmission unit (E),
m: - the transmission unit (E) being switched between the oscillator and the second reception unit (H) in such a way that the redundant clock which is generated in the oscillator is fed via the transmission unit (E) to the second reception unit (H),
n: a changeover switch (C) with one input and two outputs, the input of the changeover switch (C) being connected to the output of the transmission unit (E), one output of the changeover switch (C) being connected to an equivalent line (B) which is suitable for simulating the system clock bus, and the other output being connected to the system clock bus,
o: a divider (L) which is implemented as a frequency divider,
p: - which is connected between the oscillator and the phase detector (G), the divider (L) and the second reception unit (H) each having a control input for switching the divider (L) and the second reception unit (H) active and passive, and
q: a reference clock changeover switch (F), the output of which is connected to the output of the first reception unit (D), and is used to provide at least one master clock, the reference clock changeover switch (F) and the first reception unit (D) each having a control input for switching the reference clock changeover switch (F) and the first reception unit (D) active and passive,
r: the changeover switch (C) being suitable for switching the clock which is received from the transmission unit (E) to the system clock bus or the equivalent line (B), and the reference clock changeover switch (F) being suitable for feeding at least one reference clock, the frequency of which is lower than the frequency of the system clock, to the phase detector (G).

2. Clock supply unit according to Claim 1, **characterized in that** the oscillator is in the form of a voltage-controlled oscillator, the control voltage of which depends on the output signal of the phase detector (G).

3. Clock supply unit according to Claim 1, **characterized in that** the first (D) and second (H) reception units have the same time delay.

4. Clock supply device for changing over from a disturbed slave clock to a redundant clock, containing two clock supply units according to Claim 1 and a common control unit to control the changeover switches (C) and for switching the reference clock changeover switches (F), the dividers (L) and the first and second reception units (D, H) of the clock supply units active and passive.

5. Method
s. of changing over from a disturbed slave clock
t. - to a redundant clock, with the following steps:
u. tapping a system clock, which is fed into a system clock bus, and which corresponds to the disturbed slave clock to be changed over,
v. generating a redundant clock
w. - and synchronising the redundant clock to the system clock,
x. feeding the synchronised, redundant clock into the system clock bus,
y. preventing the disturbed slave clock from being fed into the system clock bus any more, and
z. synchronising the redundant clock to a received master clock, which has a lower frequency compared with the system clock.

## Revendications

1. Unité d'alimentation d'horloge
a : pour la commutation d'une horloge esclave perturbée
b : - vers une horloge redondante, comprenant
c : un comparateur de phases (G) pour la comparaison de la phase d'une première horloge avec la phase d'une seconde horloge,
d : une première unité de réception (D)
e : - pour prélever une horloge de système introduite dans un bus d'horloge de système, laquelle correspond à l'horloge esclave perturbée à commuter,
f: - et pour transmettre l'horloge de système au comparateur de phases (G),
g : un oscillateur
h : - pour générer l'horloge redondante,
i : une seconde unité de réception (H), qui présente les mêmes paramètres que la première unité de réception (D)
j : et sert à recevoir l'horloge redondante et à la transmettre
k : - au comparateur de phases (G),
l : une unité de transmission (E),
m : - sachant que l'unité de transmission (E) est commutée de telle sorte entre l'oscillateur et la seconde unité de réception (H) que l'horloge redondante générée dans l'oscillateur est introduite dans la seconde unité de réception (H) par l'intermédiaire de l'unité de transmission (E),
n : un commutateur (C) avec une entrée et deux sorties, sachant que l'entrée du commutateur (C) est reliée à la sortie de l'unité de transmission (E), que l'une des sorties du commutateur (C) est reliée à une ligne artificielle (B) qui est adaptée à simuler le bus d'horloge de système, et que l'autre sortie est reliée avec le bus d'horloge de système,
o : un diviseur (L) conçu sous forme de diviseur de fréquence,
p : - qui est commuté entre l'oscillateur et le comparateur de phases (G), sachant que le diviseur (L) et la seconde unité de réception (H) présente respectivement une entrée de commande pour la commutation active et passive du diviseur (L) et de la seconde unité de réception (H) et
q : un commutateur d'horloge de référence (F) dont la sortie est reliée à la sortie de la première unité de réception (D) et sert à la mise à disposition d'au moins une horloge maîtresse, sachant que le commutateur d'horloge de référence (F) et la première unité de réception (D) présentent respectivement une entrée de commande pour la commutation active et passive du commutateur d'horloge de référence (F) et de la première unité de réception (D),
r : sachant que le commutateur (C) est adapté à commuter l'horloge reçue par l'unité de transmission (E) vers le bus d'horloge de système ou la ligne artificielle (B), et sachant que le commutateur d'horloge de référence (F) est adapté à alimenter le comparateur de phases (G) d'au moins une horloge de référence dont la fréquence est inférieure à la fréquence de l'horloge de système.

2. Unité d'alimentation d'horloge selon la revendication 1, **caractérisée en ce que** l'oscillateur est conçu sous forme d'oscillateur commandé en tension dont la tension de commande dépend du signal de sortie du comparateur de phases (G).

3. Unité d'alimentation d'horloge selon la revendication 1, **caractérisée en ce que** la première (D) et la seconde unité de réception (H) présentent la même temporisation.

4. Dispositif d'alimentation d'horloge pour la commutation d'une horloge esclave perturbée vers une horloge redondante, comprenant deux unités d'alimentation d'horloge selon la revendication 1 et une unité de commande commune pour le contrôle des commutateurs (C) ainsi que pour la commutation active et passive du commutateur d'horloge de référence (F), des diviseurs (L) et des premières et secondes unités de réception (D, H) des unités d'alimentation d'horloge.

5. Procédé
s. pour la commutation d'une horloge esclave perturbée
t. - vers une horloge redondante, comprenant les étapes suivantes :
u. prélèvement d'une horloge de système introduite dans un bus d'horloge de système, laquelle correspond à l'horloge esclave perturbée à commuter,
v. production d'une horloge redondante
w. - et synchronisation de l'horloge redondante sur l'horloge de système,
x. introduction de l'horloge redondante synchronisée dans le bus d'horloge de système,
y. empêchement de l'introduction de l'horloge esclave perturbée dans le bus d'horloge de système, et
z. synchronisation de l'horloge redondante sur une horloge maîtresse reçue qui présente une fréquence plus basse par rapport à l'horloge de système.
